# EUROPÄISCHE PATENTSCHRIFT

(11) **EP 2 934 858 B1**
(45) Veröffentlichungstag und Bekanntmachung des Hinweises auf die Patenterteilung: **08.02.2023**
(21) Anmeldenummer: 13814504.0
(22) Anmeldetag: 17.12.2013
(51) Int. Cl.: G03F 7/20, B29C 67/00, A61C 13/00, G02B 26/08, B29C 64/135, B29C 64/282, B29C 64/286

(54) **VERFAHREN ZUR HERSTELLUNG EINER HOMOGENEN LICHTVERTEILUNG**
METHOD FOR PRODUCING A HOMOGENEOUS LIGHT DISTRIBUTION
PROCÉDÉ D'OBTENTION D'UNE RÉPARTITION HOMOGÈNE DE LA LUMIÈRE

(30) Priorität: 20.12.2012 DE 102012224005
(43) Veröffentlichungstag der Anmeldung: 28.10.2015
(73) Patentinhaber: Kulzer GmbH, 63450 Hanau (DE)
(72) Erfinder: BAUER, Christian, 63825 Schöllkrippen (DE); SPATZ, Marco, 63811 Sailauf (DE)
(74) Vertreter: Bendele, Tanja
(86) Internationale Anmeldenummer: PCT/EP2013/076902
(87) Internationale Veröffentlichungsnummer: WO 2014/095864

(56) Entgegenhaltungen:
- EP-A2- 1 894 705
- US-A1- 2001 035 944
- US-A1- 2007 284 547

## Beschreibung

Die Erfindung betrifft ein Verfahren zur Herstellung einer homogenisierten Lichtmengenverteilung mit einem Flächenlichtmodulator und ein Rapid-Prototyping-Verfahren, bei dem ein solches Verfahren zur Anwendung kommt.

Bei Rapid-Prototyping-Verfahren kommen neben Ultraviolett-(UV)-Lasern auch zunehmend UV-LED-Beamer zum Einsatz. Verfahren hierzu sind beispielsweise aus der EP 1 880 830 A1 und der EP 1 894 705 A2 bekannt. Dabei wird das UV-Licht auf einen lichthärtenden Kunststoff abgebildet. Bei der Abbildung werden dabei eine Optik und ein Flächenlichtmodulator verwendet. Aufgrund der Optik kommt es zu einer inhomogenen Lichtverteilung beziehungsweise Intensitätsverteilung. Die Randbereiche des Belichtungsfelds haben dabei typischerweise eine niedrigere Intensität als die Bereiche im Zentrum des Belichtungsfelds. Dieser auch als Tonnenbild bezeichnete Effekt führt dazu, dass der lichthärtende Kunststoff nicht an jeder Stelle die gleiche Intensität erhält und daher unterschiedlich und also inhomogen aushärtet.

US2007/284547A1 offenbart ein Verfahren zur Lichtmengenverteilung mit einem Flächenlichtmodulator unter Verwendung einer üblichen Lichtquelle, wie einer Hochdrucklampe, eines Lasers oder eines Diodenarrays.

Die EP 1 982 824 A2 schlägt vor, die Intensitätsverteilung zu homogenisieren, indem die helleren Pixel des UV-Beamers auf das Intensitäts-Niveau der Pixel am Rand durch eine Grauverteilung reduziert werden.

Nachteilig ist hieran, dass die Grauverteilung nur durch eine genaue Steuerung der Intensität erreicht werden kann. Es ist also auch Aufgabe der Erfindung ein weniger aufwendiges Verfahren bereitzustellen, mit dem ein ähnlicher Effekt erzielt werden kann. Die Aufgabe der Erfindung besteht also darin, die Nachteile des Stands der Technik zu überwinden. Insbesondere soll ein weniger aufwendiges Verfahren bereitgestellt werden, bei dem eine zufriedenstellende Homogenisierung der Lichtintensität des Belichtungsfelds erreicht wird. Das Verfahren soll möglichst kostengünstig realisierbar sein.

Die Aufgaben der Erfindung werden gelöst durch ein Verfahren zur Herstellung einer homogenisierten Lichtmengenverteilung mit einem Flächenlichtmodulator, der eine Vielzahl von in Reihen und Spalten angeordneten ansteuerbaren kippbaren Mikrospiegeln aufweist, mit denen das Licht einer flächig abstrahlenden Lichtquelle reflektiert und mit Hilfe einer Optik abgebildet wird, wobei ein Belichtungsfeld der abgebildeten Lichtquelle mit dem Flächenlichtmodulator über eine Projektionsfläche geführt wird, wobei eine zur Mitte des Belichtungsfelds hin zunehmende Anzahl von Pixeln nicht beleuchtet wird, so dass im zeitlichen Integral eine Homogenisierung der Lichtintensität aller auf der Projektionsfläche beleuchteten Pixel erreicht wird.

Als Pixel wird im Rahmen der vorliegenden Erfindung eine kleinste anzusteuernde Lichtquelle verstanden, aus denen das Bild des Beamers zusammengesetzt ist.

Als Flächenlichtmodulatoren können beispielsweise die besonders gut geeigneten DLP^{®} Chips der Firma Texas Instruments eingesetzt werden.

Erfindungsgemäß ist vorgesehen, dass als flächig abstrahlende Lichtquelle ein LED-Beamer, besonders bevorzugt ein UV-LED-Beamer verwendet wird.

Der Beamer strahlt vorzugsweise Licht einer Wellenlänge ausgewählt von 180 bis 600 nm ab, vorzugsweise von 230 bis 450 nm. Generell können polychromatische Lichtquellen als Beamer verwendet werden, wobei jedoch monochromatische Lichtquellen oder auch im Wesentlichen monochromatische Lichtquellen besonders bevorzugt sind. Durch Verwendung von monochromatischen Lichtquellen kann die Lichtintensität bzw. Strahlungsintensität vereinheitlicht und damit eine homogenere Polymerisation erzielt werden. Besonders bevorzugt sind LED-UV-Beamer mit einer Wellenlänge um 385 nm. Bevorzugt sind Beamer mit einer Auflösung von größer gleich1024x800, bevorzugt größer gleich 1920x1080 Pixel, insbesondere hochauflösenden mit bis zu 100.000 oder mehr Pixeln. Besonders bevorzugt werden flächig abstrahlende Lichtquellen mit kohärenten Lichtstrahlen verwendet. Eine räumliche Kohärenz wird auch durch einen sehr geringen Abstand der Lichtquelle 1 und/oder der Baueinheit 0 vom Belichtungsfeld 5 erzielt.

Als geringer Abstand der flächigen Lichtquelle, Anordnung und/oder der Baueinheit vom Belichtungsfeld gelten 3 mm bis 500 mm, insbesondere 3 mm bis 250 mm, besonders bevorzugt 3 mm bis 150 mm, vorzugsweise 3 mm bis 50 mm alternativ kann der Abstand auch 1 mm bis 50 mm betragen. Erfindungsgemäß bilden die flächig abstrahlende Lichtquelle, der Flächenlichtmodulator und die Optik, insbesondere ein Linsensystem, eine Anordnung. Die flächig abstrahlende Lichtquelle, der Flächenlichtmodulator und die Optik, insbesondere ein Linsensystem, liegen zudem als Anordnung in einer Baueinheit vor.

Dabei kann vorgesehen sein, dass durch eine für die Ansteuerung des Beamers hinterlegte Maske, insbesondere eine programmierbare Maske, die nicht beleuchteten Pixel definiert werden, indem bestimmte Leuchtpunkte des Beamers immer ausgeschaltet bleiben. Eine Maske nach der Erfindung entspricht einem Motiv der ausgeschalteten Leuchtpunkte der Lichtquelle, wobei sich das Motiv im Belichtungsfeld als nicht beleuchtete Pixel darstellt, insbesondere als statisches Motiv nicht beleuchteter Pixel.

Durch die hinterlegte Maske wird auf einfachste Weise erreicht, dass die Lichtintensität in bestimmten Bereichen des Belichtungsfelds reduziert wird. Mit dieser Maske kann dann eine Homogenisierung des Belichtungsfelds, insbesondere eine Homogenisierung der Lichtintensität des Belichtungsfelds, besonders bevorzugt eine Homogenisierung im zeitlichen Integral der Lichtintensität des Belichtungsfelds, erreicht werden.

Alternativ zur Verwendung einer hinterlegten Maske kann auch vorgesehen sein, dass durch eine Schwärzung der Mikrospiegel oder durch einen Flächenlichtmodulator mit Lücken in der Besetzung mit Mikrospiegeln oder durch Umlenken der Leuchtpunkte durch die Mikrospiegel die nicht beleuchteten Pixel definiert werden.

Durch ein Weglassen einzelner Mikrospiegel können die Kosten für den Flächenlichtmodulator beziehungsweise die Anzahl der notwendigen Anschlüsse reduziert werden. Bei Verwendung einer Schwärzung kann auf handelsübliche vollflächig besetzte Flächenlichtmodulatoren zurückgegriffen werden.

Mit einer Weiterbildung des erfindungsgemäßen Verfahrens kann auch vorgesehen sein, dass die Anzahl der nicht beleuchteten Pixel zur Mitte hin nach Maßgabe einer Funktion zunimmt, vorzugsweise linear oder nach Maßgabe einer Parabel, besonders bevorzugt nach einer Funktion, die die auftretenden Interferenzen berücksichtigt, vorzugweise nach einer Funktion die die Kohärenz am Belichtungsfeld, vorzugsweise des zu belichtenden bzw. zu druckenden Motivs verbessert.

Hierdurch sind die aufgrund der Optik typischerweise auftretenden Abweichungen in der Intensität des Belichtungsfelds besonders gut auszugleichen. Eine solche Funktion kompensiert die Intensitätszunahme in der Mitte des Belichtungsfelds besonders gut.

Dabei kann vorgesehen sein, dass die Funktion in Abhängigkeit von der durch die Optik, insbesondere ein Linsensystem, verursachten Inhomogenität des Belichtungsfelds bestimmt wird, vorzugsweise berechnet wird.

Bevorzugt wird die Funktion in Abhängigkeit von der durch die flächige Lichtquelle, die Anordnung umfassend die flächige Lichtquelle, den Flächenlichtmodulator und/oder die Optik verursachten Inhomogenität des Belichtungsfelds bestimmt, vorzugsweise berechnet. Alternativ wird die Funktion Abhängigkeit von der durch die Baueinheit umfassend die Lichtquelle verursachten Inhomogenität berechnet.

Die Funktion, nach der die Anzahl der nicht beleuchteten Pixel zur Mitte des Beleuchtungsfelds zunimmt wird ermittelt als Funktion einer Referenz 1, die die ursprüngliche Lichtintensität der Lichtquelle im Belichtungsfeld auf der Projektionsfläche (Ebene) angibt und mit der Referenz 2, die die homogene, flächige Lichtintensität (Energiedichte in der Ebene, gemittelt über x-Pixel) der Projektionsfläche angibt korreliert wird, insbesondere über 12x13 bis 1920x1080 Pixel. Die Projektionsfläche kann auch eine größere Auflösung an Pixel umfassen.

Auch diese Maßnahme dient dazu, einen möglichst genauen Ausgleich der baubedingten Fehler in der Intensitätsverteilung auszugleichen und damit ein möglichst homogenes Belichtungsfeld zu erzeugen.

Gemäß einer besonders bevorzugten Ausführungsform des erfindungsgemäßen Verfahrens kann auch vorgesehen sein, dass die Intensitätsverteilung des Belichtungsfelds bei maximaler Beleuchtung durch die Lichtquelle und den Flächenlichtmodulator gemessen oder berechnet wird und daraus die Anzahl der nicht beleuchteten Pixel in jeder Zeile und/oder Spalte ermittelt wird.

Hiermit wird ein besonders gut geeignetes Verfahren bereitgestellt, mit dem auch spezifische Intensitätsabweichungen bestimmter Lichtquellen, wie Beamer-Typen oder einzelner Beamer auf einfache Art ausgeglichen werden können.

Gemäß einer bevorzugten Ausführung der Erfindung kann vorgesehen sein, dass die flächig abstrahlende Lichtquelle, bevorzugt die Anordnung umfassend die flächig abstrahlende Lichtquelle und/oder die Baueinheit umfassend eine flächig abstrahlende Lichtquelle über die Projektionsfläche geführt wird, um das Belichtungsfeld der abgebildeten Lichtquelle über die Projektionsfläche zu führen, wobei das Belichtungsfeld vor- und zurück über die Projektionsfläche geführt werden kann. Dies kann kontinuierlich oder diskontinuierlich erfolgen.

Hierdurch wird eine besonders leicht umzusetzende Methode bereitgestellt, um das Verfahren beim Rapid-Prototyping umzusetzen. Diese Methode ist weniger fehleranfällig als andere Methoden, insbesondere denen, in denen nur das Belichtungsfeld über die Projektionsfläche geführt wird.

Mit einer Weiterbildung des erfindungsgemäßen Verfahrens wird vorgeschlagen, dass das Belichtungsfeld periodisch über die Projektionsfläche geführt wird. Durch das periodische Überstreichen der Projektionsfläche wird eine gleichmäßigere Intensität entlang der Bewegungsrichtung des Belichtungsfelds erreicht.

Die beleuchtenden Motiveinzelbilder werden durch eine Überlagerung a) der extrahierten Motiveinzelbilder, d.h. abgeleitet aus dem zu druckenden Motiv dargestellt als einzelne Motive im Scrollvorgang bzw. Führen der Anordnung umfassend die Lichtquelle über die Projektionsfläche mit b) dem Motiv der ausgeschalteten Leuchtpunkte oder dem Motiv der Maske erhalten. Die Lichtintensität der beleuchtenden Motiveinzelbilder ist, im Vergleich zur Beleuchtung ohne Flächenlichtmodulator oder Maske, homogenisiert.

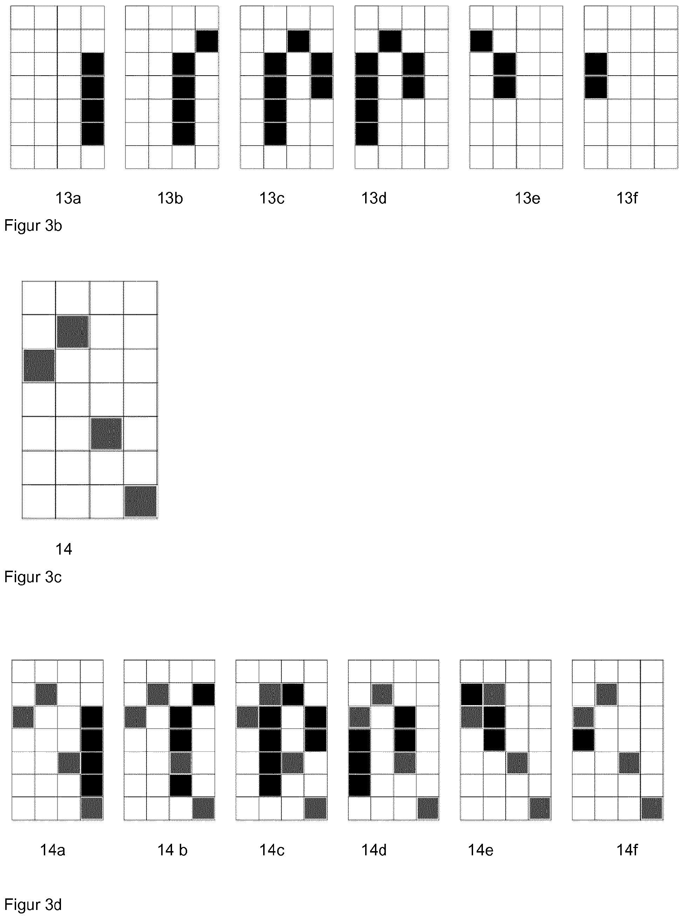

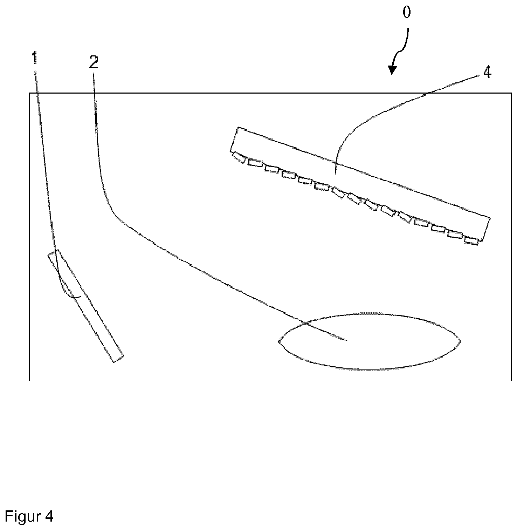

Nach einer besonders bevorzugten Ausführungsvariante werden in dem Verfahren im Belichtungsfeld beleuchtete Motiveinzelbilder erzeugt, indem eine Überlagerung a) von extrahierten Motiveinzelbilder mit b) dem Motiv der ausgeschalteten Leuchtpunkte erfolgt. Die extrahierten Motiveinzelbilder entsprechen dem zu druckenden Motiv, das in Motiveinzelbilder für den Scrollvorgang zerlegt wurde (Figur 3b).

Das Motiv der ausgeschalteten Leuchtpunkte (Figur 3c) zeigt die nicht beleuchteten Pixel, das statische Motiv von nicht beleuchteten Pixeln. Die beleuchtenden Motiveinzelbilder (Figur 3d) werden erhalten durch eine Überlagerung der jeweiligen Motiveinzelbilder (extrahierte Motiveinzelbilder, Figur 3b) mit dem statischen Motiv der ausgeschalteten Leuchtpunkte, dargestellt als statisches Motiv mit nicht beleuchteten Pixeln.

Das zu druckende Motiv wird durch ein Führen des Belichtungsfeldes mit den beleuchteten Motiveinzelbilder über die Projektionsfläche erhalten.

Es kann auch vorgesehen sein, dass als Projektionsfläche die Oberfläche eines flüssigen lichthärtenden Kunststoffs verwendet wird. Insbesondere wird ein lichthärtendes dentales Material als lichthärtender Kunststoff verwendet. Erfindungsgemäß sind das Initiatorsystem des lichthärtenden Kunststoffes und die Wellenlänge der Lichtquelle optimal aufeinander abgestimmt.

Bei der Verwendung eines flüssigen lichthärtenden Kunststoffs als Projektionsfläche ist das Verfahren zur Herstellung von dreidimensionalen Formkörpern (als sogenanntes Rapid-Prototyping Verfahren) geeignet.

Die der Erfindung zugrundeliegenden Aufgaben werden auch gelöst durch ein Rapid-Prototyping-Verfahren, bei dem ein flüssiger lichthärtender Kunststoff mit einem solchen Verfahren beleuchtet wird, vorzugsweise mit UV-Licht beleuchtet wird, wobei das Belichtungsfeld auf die Oberfläche des Kunststoffs abgebildet wird und der Kunststoff durch die Beleuchtung im Belichtungsfeld aushärtet.

Das erfindungsgemäße Verfahren zur Homogenisierung der Lichtintensität des Belichtungsfelds wirkt sich besonders bei Rapid-Prototyping-Verfahren aus, da dadurch die erzeugten Kunststoffkörper homogen aufgebaut werden können.

Der Erfindung liegt die überraschende Erkenntnis zugrunde, dass es durch das Verwenden von toten beziehungsweise immer schwarzen Pixeln, das heißt nicht leuchtenden Pixeln, gelingt, eine Homogenisierung der UV-Lichtintensität zu erreichen, ohne dass hierzu Grauwerte mit der Flächenlichtquelle eingestellt werden müssten. Dabei kann eine einmal definierte Maske verwendet werden, welche in einem Beamer, bevorzugt in einem UV-Beamer hinterlegt ist. Die Anzahl der in den Zeilen beziehungsweise Spalten schwarz definierten Pixel, hier nicht leuchtenden Pixel, steigt dabei zur Mitte des Belichtungsfelds an, um die Intensitätsabschwächung des Belichtungsfelds zum Rand hin aufgrund der Optik auszugleichen. Dies ist notwendig, da die mittleren Zeilen (beziehungsweise Spalten) konstruktionsbedingt (aufgrund der Optik) heller beleuchtet sind.

Durch erfindungsgemäße Verfahren wird der folgende Effekt erzielt. Durch die Bewegung des Beamers beziehungsweise der vom Beamer ausgehenden Strahlung, wird bei einer Belichtung die komplette Zeile des Belichtungsfelds angesteuert. Dadurch wird beim Überfahren eine maximale Lichtmenge (UV-Lichtmenge) erzeugt. Bei einem Belichtungsfeld mit beispielsweise 1920x1080 Pixeln würde die maximale Lichtmenge mit 1080 Pixeln erzeugt werden. Werden weniger Pixel angesteuert, so wird die Leistung beziehungsweise die zeitlich integrierte Lichtintensität gemindert. Auf diese Weise wird erfindungsgemäß die ungleiche Ausleuchtung der Optik ausgeglichen.

Im Folgenden werden Ausführungsbeispiele der Erfindung anhand von zwei schematisch dargestellten Figuren erläutert, ohne jedoch dabei die Erfindung zu beschränken. Dabei zeigt:
- Figur 1:: einen schematischen Aufbau in Querschnittansicht zur Umsetzung eines erfindungsgemäßen Verfahrens; und
- Figur 2:: einen schematischen Vergleich eines voll beleuchteten UV-Beamer-Chips nach dem Stand der Technik (Figur 2A) im Vergleich zu einem erfindungsgemäß betriebenen UV-Beamer-Chip (Figur 2B).
- Figur 3a:: ein zu druckendes Motiv (13), wobei die Leuchtpunkte als schwarze Pixel dargestellt sind,
- Figur 3b:: die von der Lichtquelle (1) des Beamers einzeln dargestellten Bilder (extrahierte Motiveinzelbilder (13a, 13 b, 13c, 13d, 13e, 13f) zur Erzeugung des zu druckenden Motivs (13) während der Bewegung der Lichtquelle über die Projektionsfläche (ohne Maske), wobei die Leuchtpunkte als schwarze Pixel dargestellt sind.
- Figur 3c:: ein Motiv der ausgeschalteten Leuchtpunkte (14), die über eine Maske erzeugt wird oder durch den Flächenlichtmodulator erzeugten ausgeschaltete Leuchtpunkte zum Angleichen von Beleuchtungsdifferenzen, wobei die ausgeschalteten Leuchtpunkte als graue Pixel dargestellt sind,
- Figur 3d:: eine Addition bzw. Überlagerung des Motivs der ausgeschalteten Leuchtpunkte (14), erzeugt durch den Flächenlichtmodulator und/oder die Maske und den extrahierten Motiveinzelbildern 13a bis 13f, wobei die Maske mit den ausgeschalteten Leuchtpunkten (14) als graue Pixel dargestellt sind und die Leuchtpunkte als schwarze Pixel dargestellt sind. Das aus grauen Pixeln dargestellte Motiv der ausgeschalteten Leuchtpunkte (14, Negativmotiv), ist statisch in allen Motiveinzelbildern als Überlagerung bzw. Subtraktion d.h. des Motivs der dauerhaft ausgeblendete oder geschaltete Leuchtpunkte (14) von den Motiveinzelbildern (13a bis 13f) des zu druckenden Motivs 13 abgezogen und als Überlagerung in den zu beleuchtenden Motiveinzelbildern (14a, 14, b, 14,c, 14d, 14e, 14f) dargestellt.

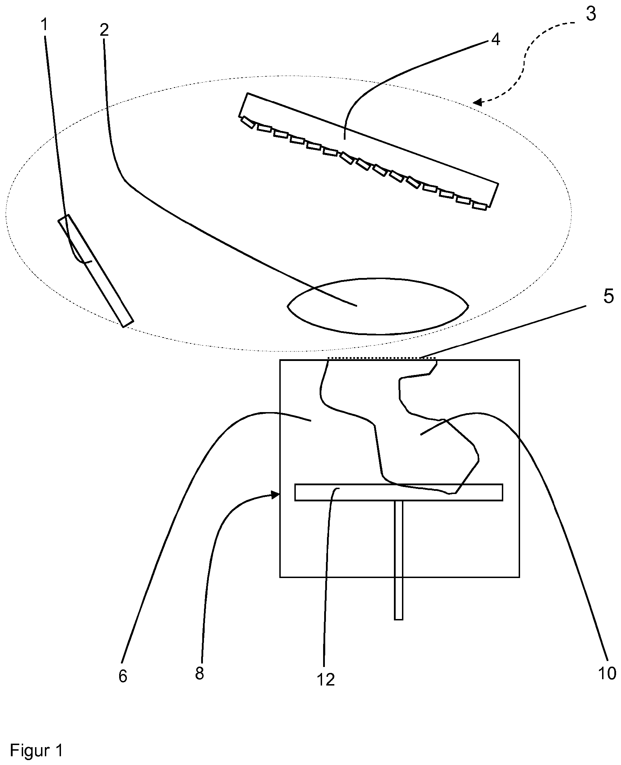

Figur 1 zeigt eine schematische Querschnittansicht eines Aufbaus zur Umsetzung eines erfindungsgemäßen Verfahrens. Ein UV-LED-Beamer 1, der ultraviolettes Licht (UV-Licht) abstrahlt, wird auf einen Flächenlichtmodulator 4 abgestrahlt. Der UV-LED-Beamer 1 hat eine Auflösung von 1920x1080 Pixeln, die als rechteckige Fläche auf der Oberfläche eines Chips des UV-LED-Beamers 1 abstrahlen. Der Flächenlichtmodulator 4 umfasst eine Vielzahl von ansteuerbaren Mikrospiegeln, mit denen das Licht aus dem UV-LED-Beamer 1 reflektiert und mit Hilfe eines Linsensystems 2 auf die Oberfläche eines flüssigen lichthärtenden Kunststoffs 6 abgebildet wird. Die Mikrospiegel sind in Figur 1 als unterschiedlich orientierte kleine Rechtecke an einer Oberfläche des Flächenlichtmodulators 4 dargestellt. Der flüssige Kunststoff 6 ist in einem Behälter 8 angeordnet, der nach oben zum Flächenlichtmodulator 4 beziehungsweise dem Linsensystem 2 offen ist.

Das Linsensystem 2, das in Figur 1 nur als einfache Linse schematisch dargestellt ist, bildet die Fläche der Pixel des UV-LED-Beamers 1 auf die Oberfläche des lichthärtenden Kunststoffs 6 ab. Mit Hilfe eines geeigneten Motors (nicht gezeigt) wird der UV-LED-Beamer 1 über den Behälter 8 gefahren und dadurch die Oberfläche des lichthärtenden Kunststoffs 6 mit dem Belichtungsfeld überstrichen, so dass jede Zeile des Chips des UV-LED-Beamers 1 jeden zu belichtenden Punkt vollständig überfährt beziehungsweise überfahren kann.

Das dadurch entstehende Belichtungsfeld auf der Oberfläche des lichthärtenden Kunststoffs 6 härtet die flüssigen Bestandteile aus, so dass ein fester Kunststoffkörper 10 entsteht. Der feste Kunststoffkörper 10 ist auf einer Halterung 12 gelagert, die langsam nach unten abgesenkt wird, so dass die obere Oberfläche des Kunststoffkörpers 10 von dem flüssigen lichthärtenden Kunststoff 6 benetzt wird und eine neue feste Schicht mit Hilfe des Belichtungsfelds auf dem Kunststoffkörper 10 erzeugt werden kann. Für Details zur Umsetzung sei auf die EP 1 880 830 A1 oder die EP 1 894 705 A2 verwiesen.

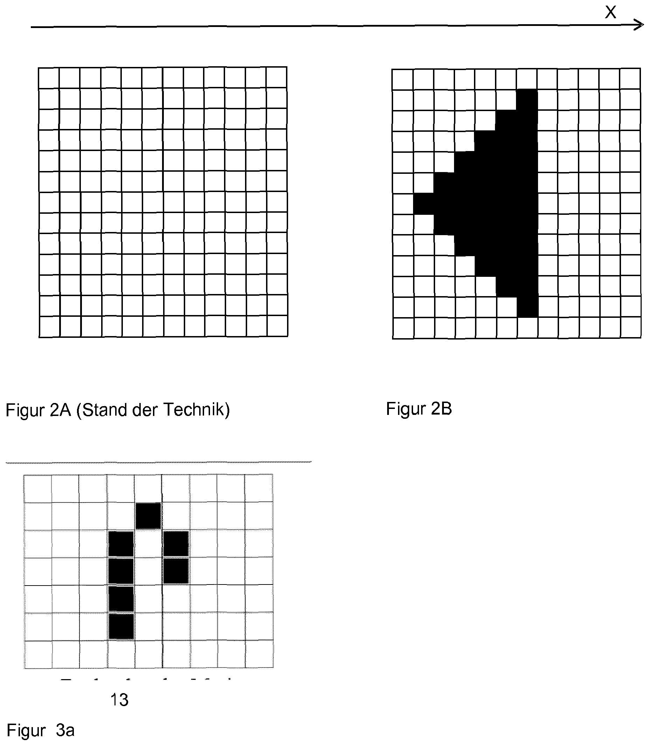

Eine Homogenisierung des Lichtfelds und damit des erzeugten Kunststoffkörpers 10 wird dadurch erreicht, dass die in der Mitte des Chips des UV-LED-Beamers 1 angeordneten Pixel nicht verwendet werden, das heißt, dass diese schwarz bleiben. Zum besseren Verständnis ist eine erfindungsgemäße Verwendung beziehungsweise eine erfindungsgemäße Steuerung eines solchen Chips in Figur 2B gezeigt und wird im Folgenden erläutert.

Figur 2 zeigt einen schematischen Vergleich eines voll beleuchteten UV-Beamer-Chips (Figur 2A) nach dem Stand der Technik im Vergleich zu einem erfindungsgemäß betriebenen UV-Beamer-Chip (Figur 2B). Der Beispielhaft gezeigte UV-LED-Chip hat nur 12x13 Pixel, damit das Grundprinzip der vorliegenden Erfindung einfach veranschaulicht werden kann. In einer realen Ausführung kommen UV-LED-Beamer mit einer wesentlich höheren Auflösung zum Einsatz, wie beispielsweise 1920x1080 Pixel.

Jeder der UV-LED-Chips hat 12 Spalten und 13 Zeilen. Bei dem voll beleuchteten UV-LED-Chip nach dem Stand der Technik (Figur 2A) werden die inneren Bereiche des Belichtungsfelds mit einer höheren UV-Intensität bestrahlt, als die äußeren Bereiche. In der mittleren Spalte entsteht dadurch die höchste Intensität, die nach außen abnimmt. Aufgrund von Streueffekten und anderen durch die Optik auftretenden Eigenschaften, können die einzelnen Pixel des UV-LED-Beamers nicht beliebig scharf abgebildet werden. Jeder Pixel beleuchtet also auch die Bereiche des Belichtungsfelds, die eigentlich durch seine benachbarten Pixel beleuchtet werden müssten. Dadurch erhalten die durch die inneren Pixel bestrahlten Bereiche des Belichtungsfelds eine höhere Intensität als die durch die äußeren Pixel bestrahlten Bereiche des Belichtungsfelds.

Dies wird bezüglich der Spalten (In Figur 2 von oben nach unten) dadurch ausgeglichen, dass der UV-LED-Beamer entlang einer Bewegungsrichtung X über das Belichtungsfeld gefahren wird. Die Bewegungsrichtung X des UV-LED-Beamers beziehungsweise des Belichtungsfelds ist in den beiden Figuren 2A und 2B durch den Pfeil angegeben. Das von den UV-LED-Chips abgestrahlte Bild wird also in Richtung der Zeilen (In Figur 2 von links nach rechts, das heißt entlang des Pfeils X) über das Belichtungsfeld bewegt. Zur Abbildung kann ein DLP^{®} Chip der Firma Texas Instruments eingesetzt werden.

Durch die in Figur 2B gezeigten schwarzen Pixel, die ausgeschaltet bleiben oder die vom Flächenlichtmodulator nicht auf die Oberfläche des flüssigen lichthärtenden Kunststoffs reflektiert werden, wird die Lichtintensität in den verschiedenen Spalten des erfindungsgemäß betriebenen UV-LED-Beamers zur Mitte hin immer stärker reduziert. Dadurch wird erreicht, dass die mittleren Bereiche des entlang der Bewegungsrichtung X überstrichenen Belichtungsfelds die gleiche Intensität ultravioletter Strahlungsintensität erhalten, wie die äußeren Bereiche (Zeilen).

Die einfachste Ausführung für ein erfindungsgemäßes Verfahren kann dadurch realisiert werden, dass für den Beamer eine Maske hinterlegt wird, die definiert, welche der Pixel nicht eingeschaltet beziehungsweise benutzt werden und daher schwarz bleiben. Alternativ kann aber auch ein Flächenlichtmodulator verwendet werden, der im Bereich der Mitte weniger oder geschwärzte Spiegel aufweist.

In Figur 2B werden nur die äußersten beiden Zeilen mit allen zwölf Pixeln bestrahlt, während für jede Zeile, die dichter an der mittleren Zeile liegt, jeweils ein Pixel weniger leuchtet beziehungsweise abgebildet wird. In der mittleren Zeile sind dann nur noch sechs Pixel aktiv beziehungsweise es werden nur noch sechs Pixel abgebildet. Beim Überstreichen der Belichtungsfläche entlang der Bewegungsrichtung X wird eine mittlere Belichtungsintensität an den beleuchteten Stellen des Belichtungsfelds erzeugt, die unmittelbar proportional zur Anzahl der verwendeten beziehungsweise abgebildeten Pixel des UV-LED-Beamers ist. Geeignete Beamer können eine Auflösung von bis zu 100.000 oder bis zu 1,5 Millionen Pixel aufweisen. Ebenso können Beamer mit einer Darstellungen in XGA und Super-XGA (SXGA) mit 1.280 x 1.024 Bildpunkten eingesetzt werden.

Um eine gleichmäßig homogenisierte Lichtmengenverteilung auf der Oberfläche des lichthärtenden Kunststoffs beziehungsweise der Projektionsfläche zu erzielen, wird das Belichtungsfeld mit einer konstanten Geschwindigkeit über eine Bauplattform geführt. Die Bauplattform ist hier 1.920 x 20.000 Pixel groß (Pixelgröße hier 50 x 50 µm). Während der Bewegung werden Bildausschnitte über das Belichtungsfeld fortlaufend wiedergegeben.

Die einmal definierte Maske, welche im UV-Beamer hinterlegt ist, erzeugt in den einzelnen Zeilen tote (immer schwarze) Pixel. In diesem Fall steigt die Anzahl der in den Zeilen schwarz definierten Pixel zur Mitte hin an, da die mittleren Zeilen konstruktionsbedingt (durch Optik) heller beleuchtet sind.

Der Effekt ist folgender: Durch die Bewegung des UV-Beamers, wird bei einer Belichtung die komplette Zeile des Belichtungsfeldes angesteuert. So wird beim Überfahren eine maximale UV-Lichtmenge mit 1080 erzeugt. Werden weniger Pixel angesteuert, so wird die Leistung gemindert und es kann so die ungleiche Ausleuchtung der Optik ausgeglichen werden.

Figur 3a zeigt ein zu druckendes Motiv 13, in dem die Leuchtpunkte als schwarze Pixel dargestellt sind. In Figur 3b ist die Abfolge der von der Lichtquelle einzeln dargestellten Bilder (extrahierte Motiveinzelbilder 13a, 13 b, 13c, 13d, 13e, 13f) zur Erzeugung des zu druckenden Motivs 13 während der Bewegung der Lichtquelle oder der Anordnung über die Projektionsfläche (ohne Motiv der ausgeschalteten Leuchtpunkte und/oder ohne Maske) dargestellt. Die Leuchtpunkte sind als schwarze Pixel dargestellt. In Figur 3c ist das Motiv der ausgeschalteten Leuchtpunkte 14 wiedergegeben. Das Motiv der ausgeschalteten Leuchtpunkte wird durch den Flächenlichtmodulator und/oder die Maske erzeugt. Die ausgeschalteten Leuchtpunkte sind als graue Pixel dargestellt. So können durch den Flächenlichtmodulator Leuchtpunkte ausgeschaltet oder umgelenkt werden, um ein Angleichen von Beleuchtungsdifferenzen zu erzielen.

In Figur 3d ist die Überlagerung des Motivs der ausgeschalteten Leuchtpunkte 14, insbesondere des statischen Motivs, erzeugt durch den Flächenlichtmodulator und/oder die Maske und den extrahierten Motiveinzelbildern 13a bis 13f dargestellt. Das Motiv der ausgeschalteten Leuchtpunkten 14 oder die Maske sind als graue Pixel dargestellt. Die beleuchteten Pixel im Belichtungsfeld sind als schwarze Pixel dargestellt und bilden die zu beleuchtenden Motiveinzelbilder (14a, 14, b, 14c, 14d, 14e, 14f).

### Bezugszeichenliste

- 0: Baueinheit umfassend Lichtquelle (1), wie UV-LED-Beamer (1), Optik, insbesondere Linsensystem (2), Flächenlichtmodulator (4),
- 1: UV-LED-Beamer
- 2: Linsensystem
- 3: Anordnung der flächigen Lichtquelle (1), des Flächenlichtmodulator (4) und/oder der Linsensystem/Optik (2)
- 4: Flächenlichtmodulator
- 5: Belichtungsfeld
- 6: Lichthärtender flüssiger Kunststoff
- 8: Behälter
- 10: ausgehärteter lichthärtender Kunststoff / Kunststoffkörper
- 12: Halterung
- 13: zu druckendes Motiv,
- 13a bis 13 f: einzeln dargestellten Bilder (13a, 13 b, 13c, 13d, 13e, 13f) zur Erzeugung des zu druckenden Motivs
- 14: Motiv der ausgeschalteten Leuchtpunkte/Motiv nicht beleuchtete Pixel
- 14a bis 14 f: zu beleuchtende Motiveinzelbilder mit homogenisierter Lichtmengenverteilung. Einzeln dargestellten Bilder (14a, 14b, 14c, 14d, 14e, 14f) zur Erzeugung des zu druckenden Motivs 13, dargestellt als einzeln dargestellte Bilder (13a, 13b, 13c, 13d, 13e, 13f) zur Erzeugung des zu druckenden Motivs beim Scrollen mit einer statischen Überlagerung des Motivs der ausgeschalteten Leuchtpunkte (14)

## Patentansprüche

1. Verfahren zur Herstellung einer homogenisierten Lichtmengenverteilung mit einem Flächenlichtmodulator (4), der eine Vielzahl von in Reihen und Spalten angeordneten ansteuerbaren kippbaren Mikrospiegeln aufweist, mit denen das Licht einer flächig abstrahlenden Lichtquelle (1) reflektiert und mit Hilfe einer Optik (2) abgebildet wird, wobei ein Belichtungsfeld der abgebildeten Lichtquelle (1) über eine Projektionsfläche geführt wird, wobei eine zur Mitte des Belichtungsfelds hin zunehmende Anzahl von Pixeln nicht beleuchtet wird, so dass im zeitlichen Integral eine Homogenisierung der Lichtintensität aller auf der Projektionsfläche beleuchteten Pixel erreicht wird, **dadurch gekennzeichnet, dass** die Lichtquelle ein LED-Beamer (1) ist.

2. Verfahren nach Anspruch 1, **dadurch gekennzeichnet, dass** als flächig abstrahlende Lichtquelle (1) ein UV-LED-Beamer (1) verwendet wird.

3. Verfahren nach Anspruch 2, **dadurch gekennzeichnet, dass** durch eine für die Ansteuerung des Beamers (1) hinterlegte Maske die nicht beleuchteten Pixel definiert werden, indem bestimmte Leuchtpunkte des Beamers (1) immer ausgeschaltet bleiben.

4. Verfahren nach einem der Ansprüche 2 oder 3, **dadurch gekennzeichnet, dass** durch eine für die Ansteuerung des Beamers (1) hinterlegte programmierbare Maske die nicht beleuchteten Pixel definiert werden, indem bestimmte Leuchtpunkte des Beamers (1) immer ausgeschaltet bleiben.

5. Verfahren nach einem der Ansprüche 1 bis 4, **dadurch gekennzeichnet, dass** durch eine Schwärzung der Mikrospiegel, durch einen Flächenlichtmodulator (4) mit Lücken in der Besetzung mit Mikrospiegeln oder durch Umlenken von Leuchtpunkten des Beamers durch die Mikrospiegel die nicht beleuchteten Pixel definiert werden.

6. Verfahren nach einem der Ansprüche 1 bis 5, **dadurch gekennzeichnet, dass** die Anzahl der nicht beleuchteten Pixel zur Mitte, insbesondere zur Mitte des Beleuchtungsfeldes, hin nach Maßgabe einer Funktion zunimmt, vorzugsweise linear oder nach Maßgabe einer Parabel zunimmt.

7. Verfahren nach Anspruch 6, **dadurch gekennzeichnet, dass** die Funktion in Abhängigkeit von der durch die Optik (2), insbesondere ein Linsensystem (2), verursachten Inhomogenität des Belichtungsfelds bestimmt wird, vorzugsweise berechnet wird.

8. Verfahren nach einem der Ansprüche 1 bis 7, **dadurch gekennzeichnet, dass** die flächig abstrahlende Lichtquelle (1), der Flächenlichtmodulator (4) und die Optik (2) eine Anordnung (3) bilden und/oder die flächig abstrahlende Lichtquelle (1), der Flächenlichtmodulator (4) und die Optik (2), insbesondere ein Linsensystem, als Anordnung (3) in einer Baueinheit (0) vorliegen.

9. Verfahren nach einem der Ansprüche 6 oder 7, **dadurch gekennzeichnet, dass** die Funktion in Abhängigkeit von der durch die flächige Lichtquelle (1), eine Anordnung (3) umfassend die flächige Lichtquelle (1), den Flächenlichtmodulator (4) und/oder die Optik (2) verursachten Inhomogenität des Belichtungsfelds bestimmt wird, vorzugsweise berechnet wird.

10. Verfahren nach einem der Ansprüche 8 bis 9, **dadurch gekennzeichnet, dass** die Intensitätsverteilung des Belichtungsfelds bei maximaler Beleuchtung durch die Lichtquelle (1) und den Flächenlichtmodulator (4), die Lichtquelle der Anordnung (3) oder die Lichtquelle der Baueinheit (0) gemessen oder berechnet wird und daraus die Anzahl der nicht beleuchteten Pixel in jeder Zeile und/oder Spalte ermittelt wird.

11. Verfahren nach einem der Ansprüche 1 bis 10, **dadurch gekennzeichnet, dass** das Belichtungsfeld periodisch über die Projektionsfläche geführt wird, wobei vorzugsweise als Projektionsfläche die Oberfläche eines flüssigen lichthärtenden Kunststoffs (10) verwendet wird.

12. Verfahren nach einem der Ansprüche 8 bis 11, **dadurch gekennzeichnet, dass** die Anordnung (3) umfassend die flächig abstrahlende Lichtquelle (1), die Baueinheit (0) umfassend eine flächig abstrahlende Lichtquelle (1), oder die flächig abstrahlende Lichtquelle (1) über die Projektionsfläche geführt wird, um das Belichtungsfeld der abgebildeten Lichtquelle (1) über die Projektionsfläche zu führen.

13. Verfahren nach einem der Ansprüche 1 bis 12, **dadurch gekennzeichnet, dass** als flächig abstrahlende Lichtquelle (1) der LED-Beamer (1) mit einer Strahlung mit einer Wellenlänge zwischen 180 bis 400 nm verwendet wird, bevorzugt einer Strahlung um 385 nm.

14. Verfahren nach einem der Ansprüche 1 bis 13, **dadurch gekennzeichnet, dass** im Belichtungsfeld beleuchtete Motiveinzelbilder (14a-f) erzeugt werden durch eine Überlagerung von extrahierten Motiveinzelbilder (13a-f) mit dem Motiv ausgeschalteter Leuchtpunkte (14) des Beamers.

15. Rapid-Prototyping-Verfahren, bei dem ein flüssiger lichthärtender Kunststoff (10) mit einem Verfahren nach einem der vorangehenden Ansprüche 1 bis 14 beleuchtet wird, vorzugsweise mit UV-Licht beleuchtet wird, wobei das Belichtungsfeld auf die Oberfläche des Kunststoffs (10) abgebildet wird und der Kunststoff (10) durch die Beleuchtung im Belichtungsfeld aushärtet.

## Claims

1. Method for producing a homogenised distribution of light quantity with a spatial light modulator (4) that comprises a multitude of controllable tiltable micro-mirrors arranged in rows and columns, in which the light of a spatially emitting light source (1) is projected by means of an optical system (2), wherein an illuminated field of the projected light source (1) is guided over a projection surface, a number of pixels increasing towards the middle of the illuminated field not being illuminated such that a homogenisation of the light intensity of all pixels being illuminated on the projection surface is attained in the time integral, **characterised in that** the light source is a LED data projector (1).

2. Method according to claim 1, **characterised in that**
a UV-LED data projector (1) is used as spatially emitting light source (1).

3. Method according to claim 2, **characterised in that**
the non-illuminated pixels are defined by a mask stored for controlling the data projector (1) by certain light points of the data projector (1) remaining switched off at all times.

4. Method according to any one of the claims 2 or 3, **characterised in that**
the non-illuminated pixels are defined by a programmable mask stored for controlling the data projector (1) by certain light points of the data projector (1) remaining switched off at all times.

5. Method according to any one of the claims 1 to 4, **characterised in that**
the non-illuminated pixels are defined by a blackening of the micro-mirrors, by a spatial light modulator (4) with voids in the micro-mirror configuration or by deflection of the light points of the projector by the micro-mirrors.

6. Method according to any one of the claims 1 to 5, **characterised in that**
the number of non-illuminated pixels increases towards the middle, in particular to the middle of the illuminated field, according to a function, preferably linearly or according to a parabola.

7. Method according to claim 6, **characterised in that**
the function is determined, preferably calculated, depending on the inhomogeneity of the illuminated field caused by the optical system (2), in particular a lens system (2).

8. Method according to any one of the claims 1 to 7, **characterised in that**
the spatially emitting light source (1), the spatial light modulator (4), and the optical system (2) form an arrangement (3), and/or the spatially emitting light source (1), the spatial light modulator (4) and the optical system (2), in particular a lens system, are present in an assembly (0) as an arrangement (3).

9. Method according to any one of the claims 6 to 8, **characterised in that**
the function is determined, preferably calculated, depending on the inhomogeneity of the illuminated field caused by the spatial light source (1), an arrangement (3) comprising the spatial light source (1), the spatial light modulator (4) and/or the optical system (2).

10. Method according to any one of the claims 8 to 9, **characterised in that**
the intensity distribution of the illuminated field is measured or calculated at maximal illumination by the light source (1) and the spatial light modulator (4), the light source (1) of the arrangement (3) or the light source of the assembly (0), and the number of non-illuminated pixels in each row and/or column is established thereof.

11. Method according to any one of the claims 1 to 10, **characterised in that**
the illuminated field is periodically guided over the projection surface, the surface of a liquid light-curing plastic material (10) preferably being used as projection surface.

12. Method according to any one of the claims 8 to 11, **characterised in that**
the arrangement (3) comprising the spatially emitting light source (1), the assembly (0) comprising a spatially emitting light source (1) or the spatially emitting light source (1) is guided over the projection surface in order to guide the illuminated field of the projected light source (1) over the projection surface.

13. Method according to any one of the claims 1 to 12, **characterised in that**
the LED data projector (1) having a radiation with a wavelength between 180 to 400 nm, preferably a radiation about 385 nm, is used as spatially emitting light source (1).

14. Method according to any one of the claims 1 to 13, **characterised in that** single images of the motif illuminated in the illuminated field (14a-f) are generated by superimposition of extracted single images of the motif (13a-f) with the motif of the switched-off light points (14) of the beamer.

15. Rapid prototyping method, in which a liquid light-curing plastic material (10) is illuminated, preferably is illuminated with UV light, using a method according to any one of the preceding claims 1 to 14, the illuminated field being projected onto the surface of the plastic material (10) and the plastic material (10) being cured by the illumination in the illuminated field.

## Revendications

1. Procédé pour produire une distribution homogénéisée de la quantité de lumière avec un modulateur spatial de lumière (4) qui comprend une multitude des micro-miroirs basculables contrôlables arrangés en rangées et en colonnes, dans lequel la lumière d'une source lumineuse émettant spatialement (1) est projetée au moyen d'un système optique (2), est un champ enluminé de la source de lumière (1) projetée est guidé au-dessus d'une surface de projection, un nombre des pixels augmentant vers le milieu du champ enluminé n'étant pas enluminé de sorte qu'une homogénéisation de l'intensité lumineuse de tous les pixels étant sur la surface de projection est atteinte en l'intégrale temps, **caractérisé en ce que** la source lumineuse est un vidéoprojecteur LED (1).

2. Procédé selon la revendication 1, **caractérisé en ce qu'**
vidéoprojecteur UV LED (1) est utilisé en tant qu'une source lumineuse émettant spatialement (1).

3. Procédé selon la revendication 2, **caractérisé en ce que**
les pixels non enluminés sont définis par un masque stocké pour contrôler le vidéoprojecteur (1) **en ce que** certains points lumineux du vidéoprojecteur (1) restent éteints tout le temps.

4. Procédé selon l'une des revendications 2 ou 3, **caractérisé en ce que**
les pixels non enluminés sont définis par un masque programmable stocké pour contrôler le vidéoprojecteur (1) **en ce que** certains points lumineux du vidéoprojecteur (1) restent éteints tout le temps.

5. Procédé selon l'une des revendications 1 à 4, **caractérisé en ce que**
les pixels non enluminés sont définis par un noircissement des micro-miroirs, par un modulateur spatial de lumière (4) avec des vides dans la configuration des micro-miroirs ou par un déflection des points lumineux par les micro-miroirs le vidéoprojecteur.

6. Procédé selon l'une des revendications 1 à 5, **caractérisé en ce que**
le nombre des pixels non enluminés augmente vers le milieu, en particulière vers le milieu du champ enluminé, conformément à une fonction, de préférence linéairement ou selon une parabole.

7. Procédé selon la revendication 6, **caractérisé en ce que**
la fonction est déterminée, de préférence calculée, en fonction de l' inhomogénéité du champ enluminé causée par le système optique (2), en particulière un système de lentilles (2).

8. Procédé selon l'une des revendications 1 à 7, **caractérisé en ce que**
la source lumineuse émettant spatialement (1), le modulateur spatial de lumière (4), et le système optique (2) forme un arrangement (3) et/ou la source lumineuse émettant spatialement (1), le modulateur spatial de lumière (4), et le système optique (2), en particular le système de lentilles, sont présents dans un assemblage (0) en tant qu'un arrangement (3).

9. Procédé selon l'une des revendications 6 ou 7, **caractérisé en ce que**
la fonction est déterminée, de préférence calculée, en fonction de l' inhomogénéité du champ enluminé causée par la source lumineuse spatial (1), un arrangement (3) comprenant la source lumineuse spatial (1), le modulateur spatial de lumière (4) et/ou le système optique (2).

10. Procédé selon l'une des revendications 8 à 9, **caractérisé en ce que**
la distribution d'intensité du champ enluminé est mesurée ou calculée à l'illumination maximale par la source lumineuse (1) et le modulateur spatial de lumière (4), la source lumineuse (1) de l'arrangement (3) ou la source lumineuse de l'assemblage (0), et le nombre des pixels non enluminés dans chaque rangée et/ou colonne est donc établi ainsi.

11. Procédé selon l'une des revendications 1 à 10, **caractérisé en ce que**
le champ enluminés est guide périodiquement au-dessus de la surface de projection, la surface d'un matériau plastique durcissant à la lumière ( 10) étant utilisée en tant qu'une surface de projection.

12. Procédé selon l'une des revendications 8 à 11, **caractérisé en ce que**
l'arrangement (3) comprenant la source lumineuse émettant spatialement (1), l'assemblage (0) comprenant la source lumineuse émettant spatialement (1) ou la source lumineuse émettant spatialement (1) est guidé au-dessus de la surface de projection afin de guider le champ enluminé de la source lumineuse (1) projetée au-dessus de la surface de projection.

13. Procédé selon l'une des revendications 1 à 12, **caractérisé en ce que**
le vidéoprojecteur LED (1) ayant une rayonnement avec un longueur d'onde entre 180 et 400 nm, de préférence une rayonnement environ 385 nm, est utilisé en tant qu'une source lumineuse émettant spatialement (1).

14. Procédé selon l'une des revendications 1 à 13, **caractérisé en ce que** des seules images du motif enluminées dans le champ enluminé (14a-f) sont générées par la superposition des seules images extraites du motif (13a-f) avec le motif des points lumineux éteints (14) le vidéoprojecteur.

15. Procédé de prototypage rapide, dans lequel un matériau plastique durcissant à la lumière (10) est enluminé, de préférence est enluminé avec la lumière UV, utilisant un procédé selon l'une des revendications 1 à 14, le champ enluminé étant projeté sur la surface du matériau plastique (1) et le matériau plastique (10) étant durci par l'illumination dans le champ enluminé.
